# FASCICULE DE BREVET EUROPEEN

(11) **EP 2 801 245 B1**
(45) Date de publication et mention de la délivrance du brevet: **13.04.2016**
(21) Numéro de dépôt: 12816736.8
(22) Date de dépôt: 19.12.2012
(51) Int. Cl.: H05K 7/14, H02M 7/00

(54) **DISPOSITIF D'ASSEMBLAGE DE CAPACITÉS POUR CONVERTISSEUR ÉLECTRONIQUE**
VORRICHTUNG ZUR MONTAGE VON KONDENSATOREN FÜR EINEN ELEKTRONISCHEN WANDLER
DEVICE FOR ASSEMBLING CAPACITORS FOR AN ELECTRONIC CONVERTER

(30) Priorité: 05.01.2012 FR 1250103
(43) Date de publication de la demande: 12.11.2014
(73) Titulaire: Valeo Equipements Electriques Moteur, 94046 Créteil Cedex (FR)
(72) Inventeur: GUERIN, Fabien, F-92320 Chatillon (FR); HOSNI, Alexis, F-75018 Paris (FR)
(74) Mandataire: Tran, Chi-Hai
(86) Numéro de dépôt international: PCT/FR2012/053000
(87) Numéro de publication internationale: WO 2013/102720

(56) Documents cités:
- EP-A2- 1 143 603
- EP-A2- 1 174 992
- WO-A1-2011/065005
- DE-A1-102005 018 172
- GB-A- 2 242 580
- US-A1- 2010 000 089
- US-A1- 2011 304 948

## Description

### DOMAINE TECHNIQUE DE L'INVENTION

La présente invention concerne un dispositif d'assemblage de capacités pour convertisseur électronique comprenant une pluralité de bras munis de transistors.

La présente invention concerne également un convertisseur électronique comportant un tel dispositif d'assemblage.

Elle trouve une application particulière mais non limitative dans le domaine des convertisseurs électroniques de machines électriques de véhicule automobile.

### ARRIÈRE-PLAN TECHNOLOGIQUE DE L'INVENTION

Classiquement, un convertisseur électronique comporte une carte de circuit imprimée appelée couramment carte PCB (pour « Printed Circuit Board » en langue anglaise), ladite carte PCB comprenant les composants électroniques formant le circuit électrique du convertisseur, à savoir des capacités, un circuit intégré, des composants électroniques discrets et des traces conductrices pour distribuer le courant au travers du circuit électrique etc.. La carte PCB est formée classiquement d'un assemblage d'une ou de plusieurs fines couches de cuivre séparées par un matériau isolant. Les couches de cuivre sont gravées par un procédé chimique pour obtenir l'ensemble de traces conductrices (également appelées pistes), terminées par des pastilles. Les traces sont souvent recouvertes d'une couche de vernis coloré permettant de protéger les pistes de l'oxydation et d'éventuels courts-circuits
Selon un état de l'art antérieur bien connu de l'homme du métier, les capacités sont directement soudées sur la carte PCB et connectées aux traces conductrices via les pastilles.

Un inconvénient de cet état de la technique réside dans le fait que l'épaisseur de la ou des couches de cuivre étant faibles, il est difficile d'utiliser un tel convertisseur électronique dans le cas d'application nécessitant de forts courants par exemple de l'ordre de 50 ampères. Par ailleurs, les traces étant positionnées les unes à côté des autres, cela créé une forte inductance qui peut perturber le fonctionnement du circuit électrique.

Dans ce contexte, la présente invention vise à résoudre les inconvénients précédemment mentionnés.

### DESCRIPTION GENERALE DE L'INVENTION

L'invention concerne un dispositif d'assemblage de capacités pour convertisseur électronique comprenant une pluralité de bras munis de transistors, ledit dispositif d'assemblage comportant un bus barre de polarité positive comprenant une pluralité de pattes d'alimentation, chaque patte d'alimentation étant adaptée pour être connectée à une électrode positive de chaque bras dudit convertisseur électronique, et un bus barre de polarité négative comprenant une pluralité de pattes d'alimentation, chaque patte d'alimentation étant adaptée pour être connectée à une électrode négative de chaque bras dudit convertisseur électronique, le bus barre de polarité positive et le bus barre de polarité négative étant superposés l'un sur l'autre sans contact électrique.

Conformément à l'invention, le bus barre de polarité positive comprend également au moins un premier orifice de positionnement adapté pour recevoir une broche positive d'une capacité et adapté pour réaliser une liaison électrique avec ladite broche positive, et au moins un premier orifice de dégagement adapté pour permettre à une broche négative d'une capacité de traverser ledit bus barre de polarité positive sans contact électrique, et le bus barre de polarité négative comprend également un deuxième orifice de dégagement adapté pour permettre à une broche positive d'une capacité de traverser ledit bus barre de polarité négative sans contact électrique, et au moins un deuxième orifice de positionnement adapté pour recevoir une broche négative d'une capacité et adapté pour réaliser une liaison électrique avec ladite broche négative, et le dispositif comporte en outre une pièce support d'isolation et d'indexation disposée entre ledit bus barre de polarité positive et ledit bus barre de polarité négative, ladite pièce support comprenant au moins une première pièce d'indexation de ladite pièce support avec le bus barre de polarité négative, et au moins un orifice de dégagement adapté pour permettre à une broche négative d'une capacité de traverser ladite pièce de support sans contact électrique.

Ainsi, le dispositif d'assemblage selon l'invention permet de réaliser un assemblage de capacités pour un convertisseur électronique de véhicule automobile en utilisant des bus barres indépendants du circuit électrique du convertisseur au lieu de pistes conductrices pour des applications à forts courant et permet ainsi de réduire l'inductance des systèmes conducteurs de courant (i.e. les bus barres) de par leur disposition:
Outre les caractéristiques principales qui viennent d'être mentionnées dans le paragraphe précédent, le dispositif d'assemblage de capacités pour convertisseur électronique de véhicule automobile selon l'invention, peut présenter une ou plusieurs caractéristiques supplémentaires ci-dessous, considérées individuellement ou selon toutes les combinaisons techniquement possibles :
   - Le bus barre de polarité positive comporte une largeur inférieure à la largeur du bus barre de polarité négative.
   - Le dispositif d'assemblage est adapté pour être disposé dans une cuve et selon lequel la pièce support d'isolation et d'indexation comporte en outre :
      - une deuxième pièce d'indexation dudit dispositif d'assemblage avec ladite cuve.
      - un orifice de fixation dudit dispositif d'assemblage dans ladite cuve.
   - Le bus barre de polarité négative et la pièce support d'isolation et d'indexation comportent un dégagement pour recevoir un écoulement d'isolant électrique dans des logements de la cuve de manière à solidariser les capacités de ladite cuve.
   - Le bus barre de polarité négative comporte en outre une fonction de détrompage pour assurer l'installation du bus barre de polarité négative sur la pièce support d'isolation et d'indexation.
   - La pièce support d'isolation et d'indexation est formée d'un matériau composite formé à partir de matière plastique PBT chargé en fibre de verre.

L'invention a également pour objet un convertisseur électronique comprenant une pluralité de bras munis de transistors, selon lequel le convertisseur électronique comporte :
- un dispositif d'assemblage selon l'une quelconque des caractéristiques précédentes ;
- une pluralité de capacités adaptées pour être assemblées par le dispositif d'assemblage ;
- une carte de circuit imprimé formant le circuit électrique dudit convertisseur électronique, ladite carte de circuit imprimé comprenant la pluralité de bras munis de transistors.

- Dans un premier mode de réalisation non limitatif, le convertisseur électronique est un onduleur pour machine électrique.
- Dans un deuxième mode de réalisation non limitatif, le convertisseur électronique est un convertisseur bidirectionnel DC/DC.

### BREVE DESCRIPTION DES FIGURES

D'autres caractéristiques et avantages de l'invention ressortiront clairement de la description qui en est donnée ci-dessous, à titre indicatif et nullement limitatif, en référence aux différentes figures annexées :
- la figure 1a représente une vue éclatée en perspective d'un premier mode de réalisation non limitatif d'un dispositif d'assemblage de capacités pour convertisseur électronique de véhicule automobile selon l'invention ;
- la figure 1b représente une vue éclatée en perspective d'un deuxième mode de réalisation non limitatif d'un dispositif d'assemblage de capacités pour convertisseur électronique de véhicule automobile selon l'invention ;
- la figure 2 représente une vue en perspective d'un premier bus barre de polarité négative du dispositif d'assemblage de la figure 1a ou de la figure 1 b ;
- la figure 3 représente une vue en perspective d'un deuxième bus barre de polarité positive du dispositif d'assemblage de la figure 1a ou de la figure 1 b ;
- la figure 4 représente une vue en perspective d'une pièce support d'indexation et de positionnement du dispositif d'assemblage de la figure 1b;
- la figure 5a représente une vue assemblée du dispositif d'assemblage illustré à la figure 1a ;
- la figure 5b représente une vue assemblée du dispositif d'assemblage illustré à la figure 1b ;
- la figure 6 représente une vue éclatée en perspective du dispositif d'assemblage illustré à la figure 5b et d'une cuve de réception dudit dispositif d'assemblage ; et
- la figure 7 représente une vue de dessus assemblée du dispositif d'assemblage de la figure 5b dans la cuve de la figure 6 et de la carte à circuit imprimé d'un convertisseur électronique ;
- la figure 8 représente un schéma simplifié d'un convertisseur électronique comprenant un dispositif d'assemblage selon les figures 1 à 7 dans le cadre d'une application machine électrique.

### DESCRIPTION DE MODES DE REALISATION DE L'INVENTION

Les éléments identiques, par structure ou par fonction, apparaissant sur différentes figures conservent, sauf précision contraire, les mêmes références.

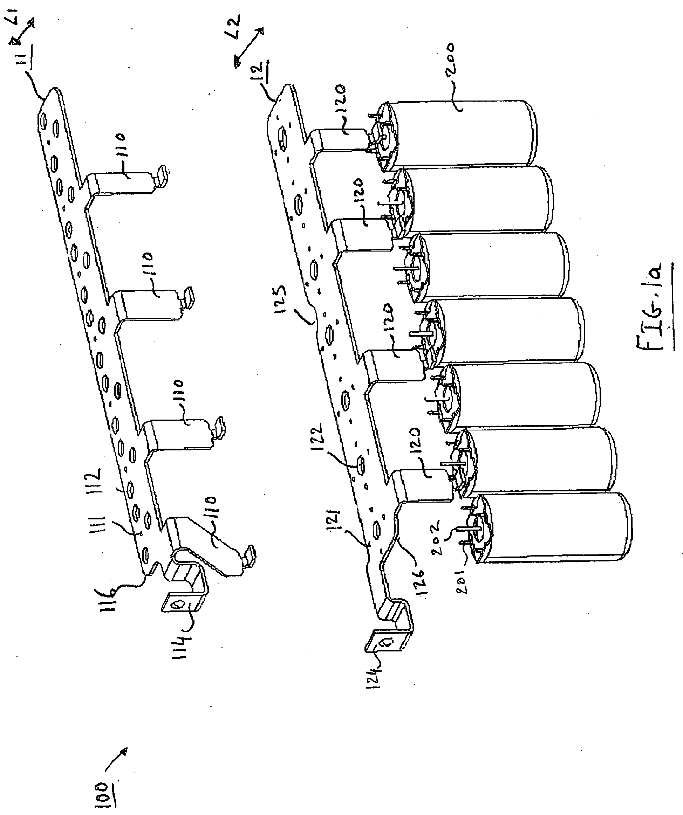

Le dispositif d'assemblage 100 de capacités 200 pour convertisseur électronique 300 comprenant une pluralité de bras 301 munis de transistors T est décrit en référence aux figures 1a à 7.

Tel qu'illustré à la figure 1a, selon un premier mode de réalisation non limitatif, le dispositif d'assemblage 100 comporte :
- un bus barre de polarité positive 11 comprenant :
   - une pluralité de pattes d'alimentation 110, chaque patte d'alimentation étant adaptée pour être connectée à une électrode positive de chaque bras 301 dudit convertisseur électronique 300 ;
   - au moins un premier orifice de positionnement 112 adapté pour recevoir une broche positive 202 d'une capacité 200 et adapté pour réaliser une liaison électrique avec ladite broche positive 202 ;
   - au moins un premier orifice de dégagement 111 adapté pour permettre à une broche négative 201 d'une capacité 200 de traverser ledit bus barre de polarité positive 11 sans contact électrique ;
- un bus barre de polarité négative 12 comprenant :
   - une pluralité de pattes d'alimentation 120, chaque patte d'alimentation étant adaptée pour être connectée à une électrode négative de chaque bras 301 dudit convertisseur électronique 300 ;
   - un deuxième orifice de dégagement 122 adapté pour permettre à une broche positive 202 d'une capacité 200 de traverser ledit bus barre de polarité négative 12 sans contact électrique ;
   - au moins un deuxième orifice de positionnement 121 adapté pour recevoir une broche négative 201 d'une capacité 200 et adapté pour réaliser une liaison électrique avec ladite broche négative 201 ;
- le bus barre de polarité positive 11 et le bus barre de polarité négative 12 étant superposés l'un sur l'autre sans contact électrique.

Dans la suite de la description, le bus barre de polarité positive 11 sera appelé également bus barre positif. De la même manière, le bus barre de polarité négatif 12 sera appelé également bus barre négatif.

### Bus barre de polarité positive

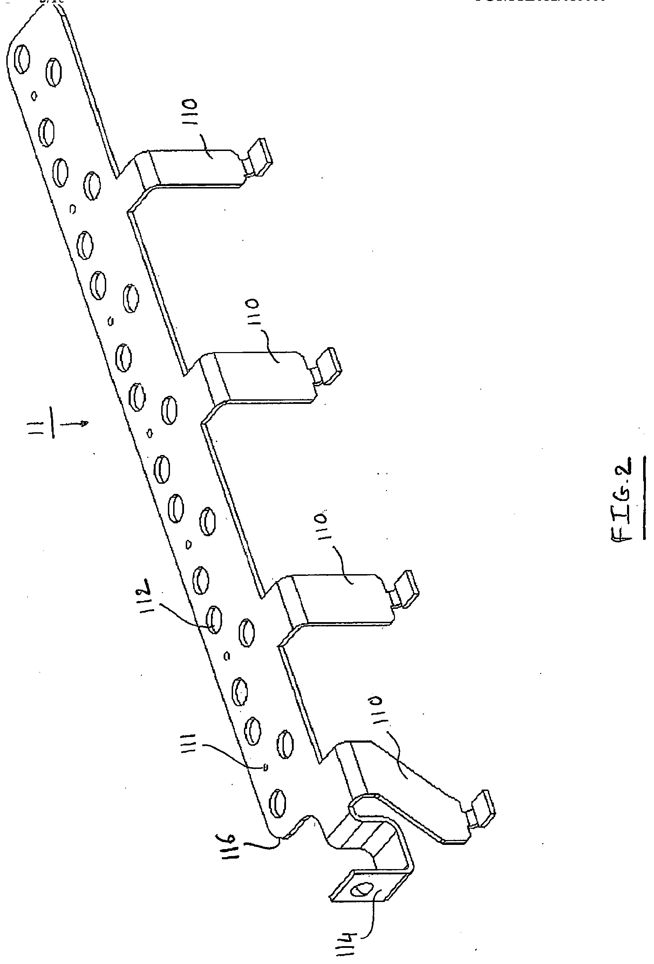

Le bus barre positif 11 est également illustré à la Fig. 2.

C'est une plaque formée de cuivre ou d'aluminium. Dans un mode de réalisation non limitatif, il peut comporter un étamage complémentaire de sorte à empêcher l'oxydation du cuivre.

Dans l'exemple illustré, la plaque est agencée de sorte à réaliser un assemblage des capacités dans une configuration alignée de manière à réduire la place occupée sur la carte PCB du convertisseur électronique 300. Dans un autre mode de réalisation, la plaque peut être agencée de sorte à réaliser un assemblage des capacités dans une configuration carrée.

Dans l'exemple non limitatif illustré, les capacités comportent une broche positive 202 et quatre broches négatives 201. Les capacités sont des capacités de type « soldering stars » à savoir des capacités axiales qui ont une broche de polarité positive centrale 202 et ici quatre broches de polarité négative 201 périphériques.

Ainsi, le bus barre positif 11, comporte pour chaque capacité 200 destinée à être assemblée par le dispositif d'assemblage:
- un premier orifice de positionnement 111 ; et
- trois premiers orifices de dégagement 112.

Le premier orifice de positionnement 111 permet d'insérer correctement la broche positive 202 d'une capacité dans le bus barre positif 11 et d'être ainsi relié électriquement au bus barre positif 11 par soudure électrique. Ce premier orifice peut présenter un faible jeu de montage par rapport au diamètre d'une broche positive.

Les premiers orifices de dégagement 112 présentent un diamètre suffisant pour permettre aux broches négatives 201 d'une capacité 200 de traverser ledit bus barre positif si ces broches sont d'une longueur supérieure à l'épaisseur du bus barre négatif et le cas échéant de la pièce support 13 (décrite plus loin), de sorte qu'en atteignant le bus barre positif 11 elles ne risquent pas d'être en connexion avec ce dernier. Cela évite ainsi un risque de court-circuit. Ainsi, ces orifices 112 permettent d'avoir une certaine tolérance de fabrication au niveau de la longueur des broches négatives 201 des capacités 200.

De plus, ces orifices 112 permettent d'accéder aux broches négatives 201 pour réaliser une soudure desdites broches. Ces orifices 112 forment ainsi un dégagement pour recevoir un ménisque de soudure lors de la soudure d'une broche, un ménisque de soudure matérialisant les effets de bord d'une soudure. En général, la soudure réalisée est une soudure à l'étain.

On notera que les pattes d'alimentation 110 sont des pattes d'alimentation positives formant une électrode positive permettant d'être connectées à une plage d'accueil sur la carte PCB de chaque bras d'un convertisseur électronique 300. La connexion se fait par la technique de brasure par refusion électrique nommée BRE. Dans un mode de réalisation non limitatif, la technique BRE utilise une sous couche de nickel et un étamage ce qui évite l'oxydation lors du puissant réchauffement de la soudure et augmente ainsi la qualité de la soudure et donc la tenue de la soudure. Ainsi, grâce aux pattes 110, l'alimentation est amenée au plus près de chaque bras du convertisseur électronique 300. Cela évite ainsi le passage du courant au travers du circuit électronique formant le convertisseur électronique 300.

Par ailleurs, le bus barre positif 11 comporte en outre :
- une fonction de détrompage 116 assurée par une asymétrie de forme et notamment par une échancrure de détrompage pour assurer l'installation du bus barre positif 11 sur la pièce support 13 au bon endroit, c'est-à-dire au dessus de ladite pièce support et non en dessous à la place du bus barre négatif 12. La fonction appelée « poke yoke » en anglais est ainsi réalisée. Cela évite ainsi les erreurs d'assemblage.
- une languette 114 adaptée pour être connectée électriquement à l'alimentation positive HV+ du convertisseur électronique. La connexion se fait par soudure électrique cuivre sur cuivre ou aluminium sur aluminium.

### Bus barre polarité négative

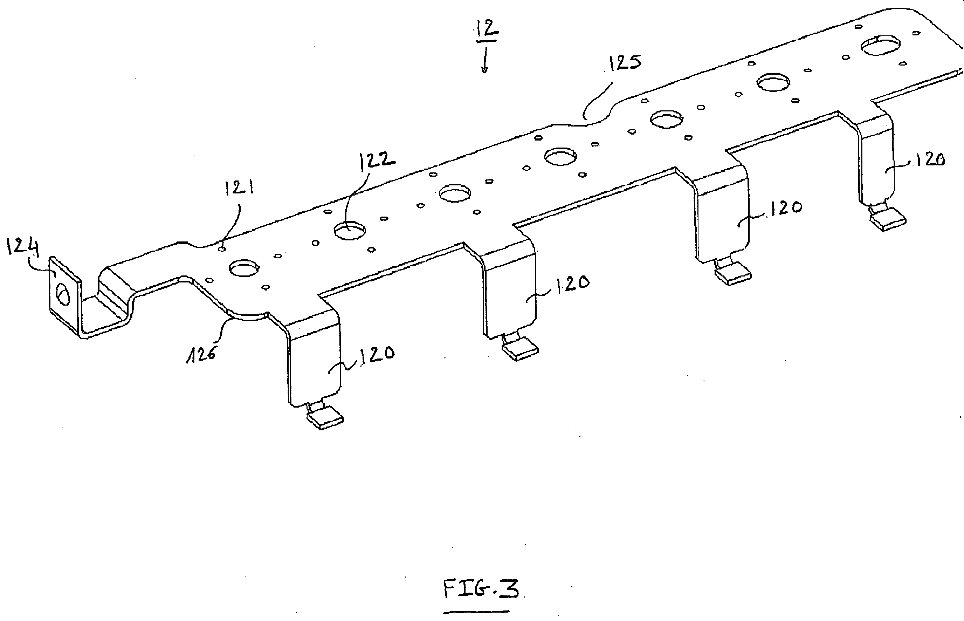

Le bus barre négatif 12 est également illustré à la Fig. 3.

Dans l'exemple non limitatif illustré, le bus barre négatif 12 comporte pour chaque capacité 200 destinée à être assemblée par le dispositif d'assemblage:
- un deuxième orifice de dégagement 122 ; et
- quatre deuxièmes orifices de positionnement 121.

Le deuxième orifice de dégagement 122 présente un diamètre suffisant pour permettre à une broche positive 202 d'une capacité 200 de traverser ledit bus barre négatif de sorte qu'en atteignant le bus barre négatif 11 elle ne risque pas d'être en connexion avec ce dernier. Cela évite ainsi un risque de court-circuit. Dans un mode de réalisation non limitatif illustré à la figure 3, le bus barre négatif 12 comporte un deuxième orifice de dégagement 122a qui a pour fonction d'indexer en longueur une première capacité 202 de l'ensemble des capacités 202. Cet orifice 122a comporte un diamètre sensiblement inférieur aux diamètres des autres orifices 122.

La première capacité et la deuxième capacité se trouvent aux deux extrémités de l'ensemble des capacités 200.

Dans un mode de réalisation non limitatif illustré à la figure 3, le bus barre négatif 12 comporte un deuxième orifice de dégagement 122b qui a pour fonction d'indexer en largeur une deuxième capacité 202 de l'ensemble des capacités 202. Cet orifice 122b a une forme ovale.

Les deuxièmes orifices de positionnement 121 permettent d'insérer correctement les broches négatives 201 d'une capacité dans le bus barre négatif 12 et d'être ainsi relié électriquement au bus barre négatif 12 par soudure. Une soudure est réalisée en général à l'étain entre les broches négatives et ces orifices 121. Ces deuxièmes orifices 121 peuvent présenter un faible jeu de montage par rapport au diamètre d'une broche négative 201.

On notera que les pattes d'alimentation 120 sont des pattes d'alimentation négatives formant une électrode négative permettant d'être connectées à une plage d'accueil sur la carte PCB de chaque bras d'un convertisseur électronique 300. La connexion se fait également par la technique de brasure par refusion électrique nommée BRE. Dans un mode de réalisation non limitatif, la technique BRE utilise une sous couche de nickel et un étamage ce qui évite l'oxydation lors du puissant réchauffement de la soudure.

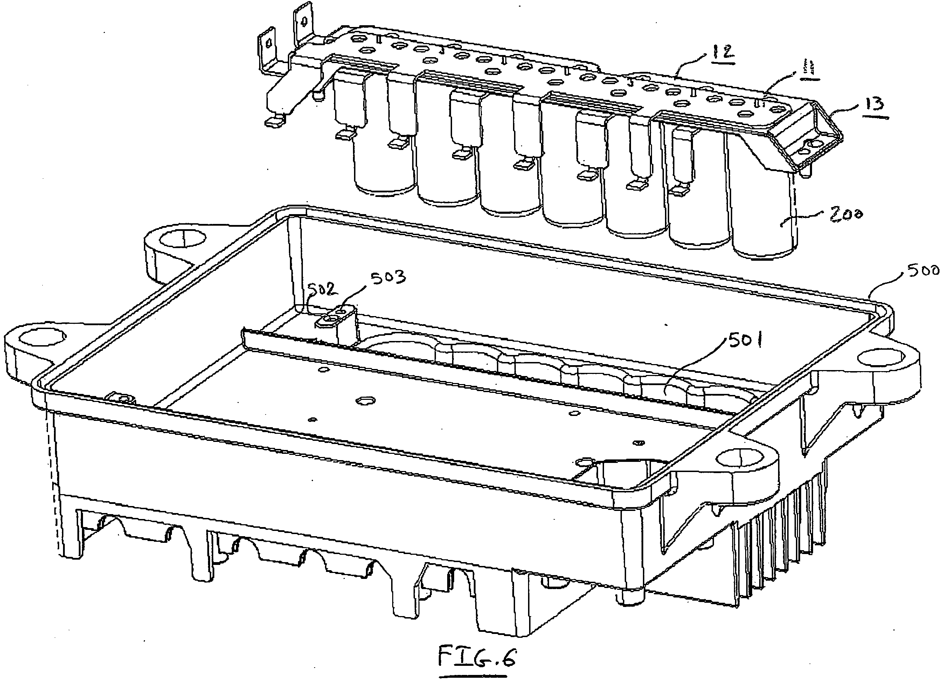

Par ailleurs, le bus barre négatif 12 comporte en outre :
- une languette 124 adaptée pour être connectée électriquement à l'alimentation négative du convertisseur électronique. La connexion se fait par soudure électrique cuivre sur cuivre ou aluminium sur aluminium ;
- un dégagement 125 pour recevoir un écoulement d'isolant électrique dans des logements 501 d'une cuve 500 de manière à solidariser les capacités 200 de ladite cuve 500, cuve dans laquelle sera disposé l'ensemble du convertisseur électronique 300, à savoir le dispositif d'assemblage 100, les capacités 200, le circuit imprimé PCB. Dans un exemple non limitatif, l'isolant électrique est une résine, par exemple en polyuréthane ou en silicone. Cela permet de remplir le jeu qui existe entre les capacités 200 et le fond des logements 501 (illustrés à la figure 6) lorsque le bloc de capacités, à savoir le dispositif d'assemblage 100 et les capacités, sera monté dans la cuve 500. Cela immobilise ainsi l'ensemble du dispositif d'assemblage et évite ainsi que l'ensemble ne soit soumis à des vibrations. De plus, cela évite que les soudures des bus barres ne soient soumises à des sollicitations mécaniques. Ce dégagement permet également de limiter la quantité de résine injectée par rapport à un autre mode de réalisation où la cuve 500 elle-même comporterait un dégagement à sa périphérie pour recevoir la résine.

Dans un mode de réalisation non limitatif, le bus barre négatif 12 comporte en outre une fonction de détrompage 126 assurée par une asymétrie de forme et notamment par une échancrure de détrompage pour assurer l'installation du bus barre négatif 12 sur la pièce support 13 au bon endroit, c'est-à-dire en dessous ladite pièce support et non au dessus à la place du bus barre positif 11. La fonction appelée « poke yoke » en anglais est ainsi réalisée. Cela évite ainsi les erreurs d'assemblage.

Dans un mode de réalisation non limitatif, le bus barre de polarité positive 11 comporte une largeur L1 inférieure à la largeur L2 du bus barre de polarité négative 12. La largeur du bus barre positif 11 sera assez grande pour que le courant puisse traverser ledit bus barre.

### Pièce support d'isolation et d'indexation

On notera que le bus barre positif 11 et le bus barre négatif 12 lorsqu'ils sont superposés l'un sur l'autre présentent un espace d'isolation E de manière à ce qu'il n'y ait aucun contact électrique entre les deux bus barres. Cet espace vide E est obtenu par la différence de longueur entre les pattes 110 du bus barre positif 11 et les pattes 120 du bus barre négatif 12, ou par des entretoises qui sont disposées entre les deux bus barres et qui restent soit le temps du montage du dispositif d'assemblage soit à demeure, ou par la différence de longueur entre les broches positives 202 et les broches négatives 201 des capacités lorsque ces dernières sont soudées.

Cependant, lorsque les soudures sont effectuées par la suite sur les pattes d'alimentation par exemple, il y a un risque que les deux bus barre se touchent lorsqu'on appuie sur les pattes pour effectuer lesdites soudures. Cela entraîne un court-circuit. Il en va de même lorsque les deux bus barres 11 et 12 sont montés dans la cuve 500. Si une pression trop forte est exercée lors du montage, il y a un risque que les deux bus barre se touchent créant ainsi un court-circuit.

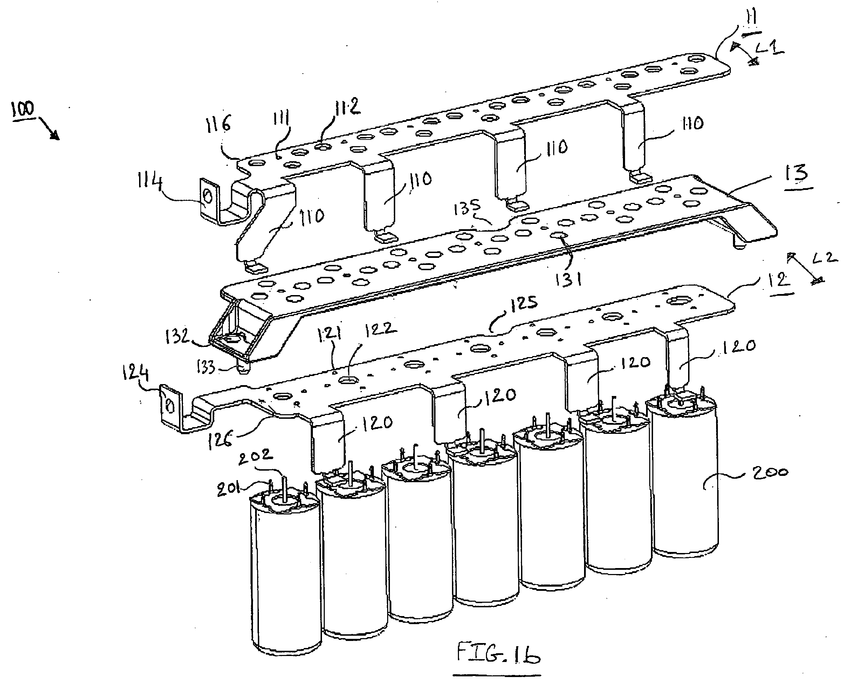

Aussi, dans un deuxième mode de réalisation non limitatif illustré à la figure 1 b, le dispositif d'assemblage 100 comporte en outre une pièce support d'isolation et d'indexation 13 disposée entre ledit bus barre de polarité positive 11 et ledit bus barre de polarité négative 12, ladite pièce support 13 comprenant :
- au moins une première pièce d'indexation 130 de ladite pièce support 13 avec le bus barre de polarité négative 12 ;
- au moins un orifice de dégagement 131 adapté pour permettre à une broche négative 201 d'une capacité 200 de traverser ladite pièce de support 13 sans contact électrique.

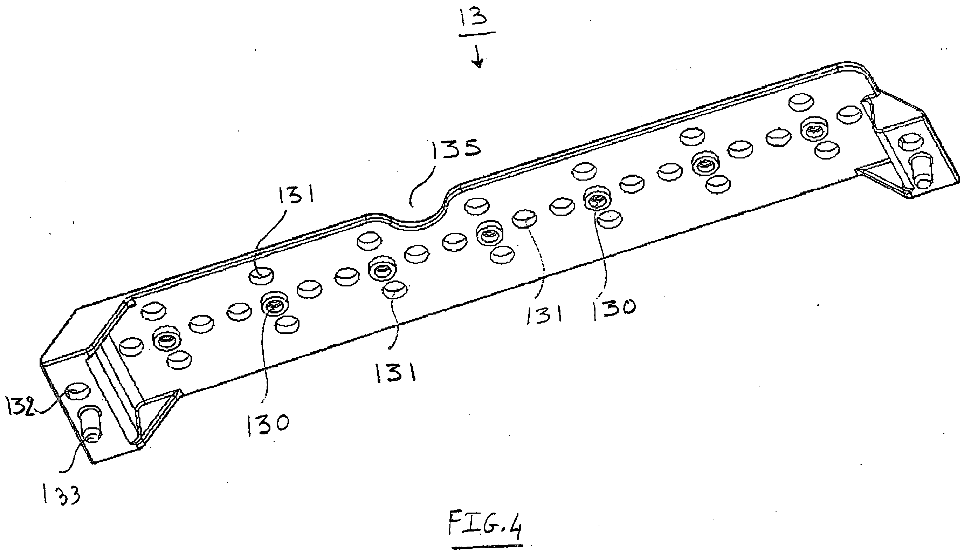

La pièce support d'isolation et d'indexation 13 également illustrée à la figure 4 est formée d'un matériau composite formé à partir de matière plastique PBT (Polybutylène téréphtalate ou Polytéréphtalate de Butylène) chargée en fibres de verre. Ce matériau permet d'obtenir de bonnes caractéristiques mécaniques et une tenue en température élevée. Cela permet ainsi de réaliser la fonction d'isolation entre les deux bus barre 11 et 12. Dans un exemple non limitatif, il peut être chargé entre 15% et 30% de fibres de verre.

La première pièce d'indexation 130 est utilisée afin de positionner correctement la pièce support 13 par rapport au bus barre négatif 12. La pièce d'indexation 130 est une pièce de forme cylindrique dont le diamètre est adapté pour venir s'ajuster dans les troisièmes orifices de dégagement 122 du bus barre négatif 12. Ainsi, la pièce support 13 comporte autant de pièces d'indexation 130 qu'il existe d'orifices de dégagement 122 sur le bus barre négatif 12, c'est-à-dire qu'il existe de capacités 200.

L'orifice de dégagement 131 présente un diamètre suffisamment important pour éviter tout contact avec une broche négative 201 d'une capacité 200 de sorte à laisser passer la broche négative 201 dans le cas où cette dernière serait plus longue que l'épaisseur du bus bar négatif 12. Dans l'exemple illustré, la pièce support comporte quatre orifices de dégagement 131 pour chaque capacité 200.

Ainsi, cet orifice de dégagement 131 permet l'accès à une broche négative 201 et forment ainsi un dégagement pour recevoir un ménisque de soudure lors de la soudure de ladite broche.

Selon un mode de réalisation non limitatif, le diamètre des orifices de dégagement 131 est identique au diamètre des orifices de dégagement 112 du bus barre positif 11 pour faciliter les soudures des broches négatives.

Bien entendu, on pourrait également utiliser une entretoise entre les deux bus barre 11 et 12 pour effectuer la fonction d'isolation.

L'orifice de fixation 132 et la deuxième pièce d'indexation 133 sont utilisés afin de positionner l'ensemble du dispositif d'assemblage 100 dans la cuve. La pièce d'indexation 133 assure un positionnement précis de la pièce support 13 dans la cuve 500. Dans l'exemple illustré, c'est un pion de positionnement. L'orifice de fixation 132 permet d'accueillir mécaniquement des moyens de fixation telle que par exemple une vis.

Comme on peut le voir à la figure 6, la cuve 500 comporte un orifice d'indexation 503 correspondant à la pièce d'indexation 133 dans lequel ladite pièce 133 sera insérée. Par ailleurs, la cuve 500 comporte un orifice de fixation 502 correspondant à l'orifice de fixation 132 de la pièce support 13 dans lesquels une vis peut être introduite.

Dans un mode de réalisation non limitatif, la pièce support d'isolation et d'indexation 13 comporte en outre un dégagement 135 pour recevoir un écoulement d'isolant électrique dans des logements 501 de la cuve 500 de manière à solidariser les capacités 200 de ladite cuve 500.

Dans un exemple non limitatif, l'isolant électrique est une résine. Ce dégagement 135 a la même fonction que le dégagement 125 du bus barre négatif décrit précédemment.

Ainsi, le montage des éléments du dispositif d'assemblage 100 présente les étapes de :
- positionner le bus barre négatif 12 et les capacités 200 au moyen des premiers orifices de positionnement 111 dans lesquels les broches négatives 201 des capacités s'insèrent. Le positionnement s'effectue soit en positionnant les capacités 200 une par une sur le bus barre 12, soit en positionnant le bus barre 12 sur les capacités 200 qui sont pré-alignées au moyen d'un gabarit.
- souder les broches négatives 201 des capacités 200 sur le bus barre négatif 12. On notera que cette soudure peut se faire après avoir assemblé le bus barre positif 11.
- positionner la pièce support d'isolation et d'indexation 13 sur le bus barre négatif 12 au moyen des pièces d'indexation 130 qui sont insérées dans les deuxièmes orifices de dégagement 122 dans le cas où la pièce support 13 est utilisée ;

- positionner le bus barre positif 11 sur la pièce support d'isolation et d'indexation 13 au moyen des premiers orifices de positionnement 111 dans lesquels les broches positives 202 s'insèrent ;
- souder les broches positives 202 des capacités 200 sur le bus barre positif 11.

On notera que la soudure électrique des broches des capacités peut se faire par soudure laser ce qui permet d'obtenir un bord effilé au niveau d'une broche. On peut par ailleurs réaliser un étamage complémentaire ou non.

Lorsque l'ensemble dispositif d'assemblage 100 et capacités 200 sont assemblés, l'ensemble appelé bloc de capacités est monté dans la cuve 500.

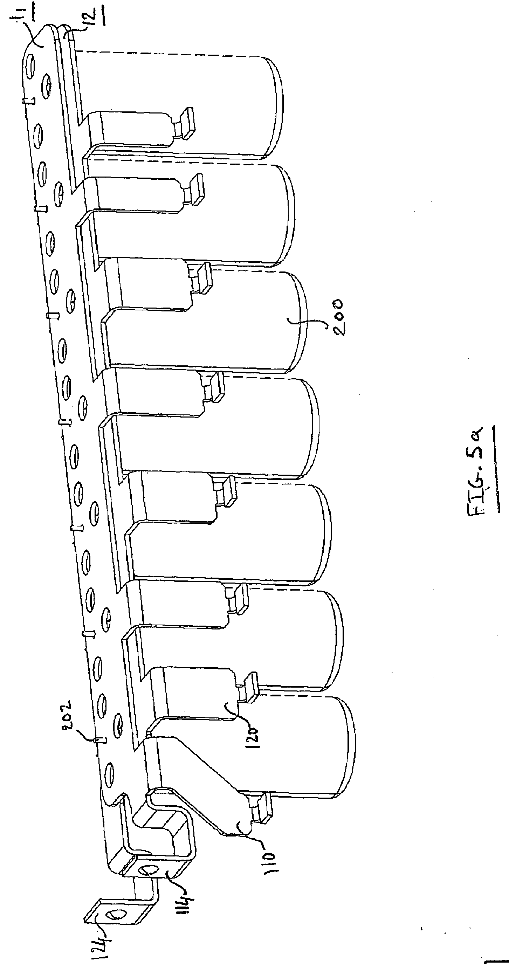

La figure 5a illustre l'ensemble des pièces du dispositif d'assemblage montées avec les capacités 200 selon le premier mode de réalisation du dispositif d'assemblage 100 sans pièce support 13.

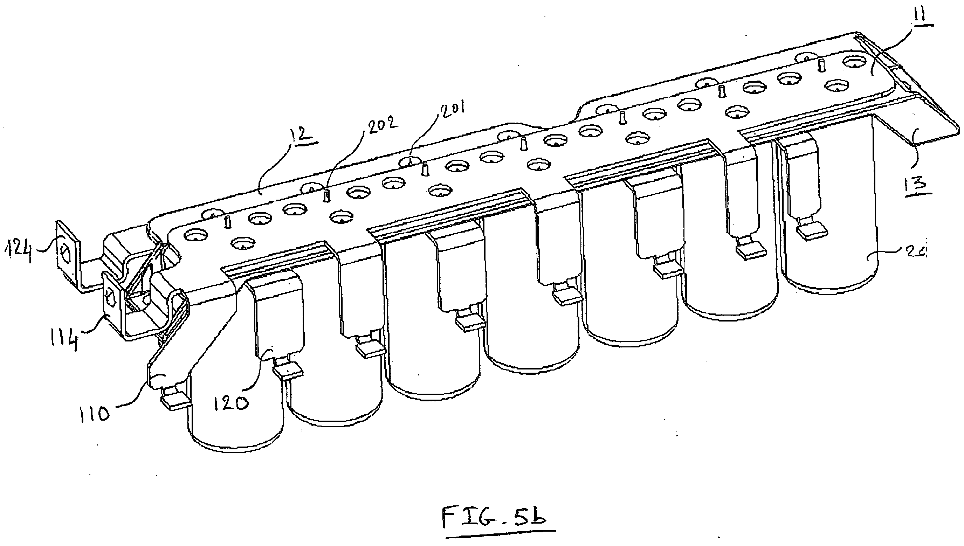

La figure 5b illustre l'ensemble des pièces du dispositif d'assemblage montées avec les capacités 200 selon le deuxième mode de réalisation du dispositif d'assemblage 100 avec pièce support 13.

Comme décrit précédemment, le dispositif d'assemblage 100 permet d'assembler des capacités 200 pour un convertisseur électronique 300. Tel qu'illustré à la figure 6, le dispositif d'assemblage 100 est disposé dans une cuve 500 qui comporte :
- des logements 501 pour recevoir les capacités 200 assemblées. Ces logements ont une forme cylindrique pour recevoir les capacités cylindriques et ont un diamètre sensiblement supérieur au diamètre des capacités de sorte à présenter un jeu ;
- un orifice d'indexation 503 correspondant à la pièce d'indexation 133 dans lequel ladite pièce 133 sera insérée ;
- un orifice de fixation 502 correspondant à l'orifice de fixation 132 de la pièce support 13 dans lesquels une vis peut être introduite.

On notera que la pièce d'indexation 133 permet d'assurer un positionnement précis des capacités 200 dans leur logement respectif 501. Les capacités 200 sont ainsi concentriques par rapport aux logements cylindriques 501. Ainsi, les capacités 200 ne toucheront pas la cuve 500 lors de montage et donc ne subiront pas de contrainte. Il n'y a ainsi pas de risque d'abîmer lesdites capacités.

### Convertisseur électronique

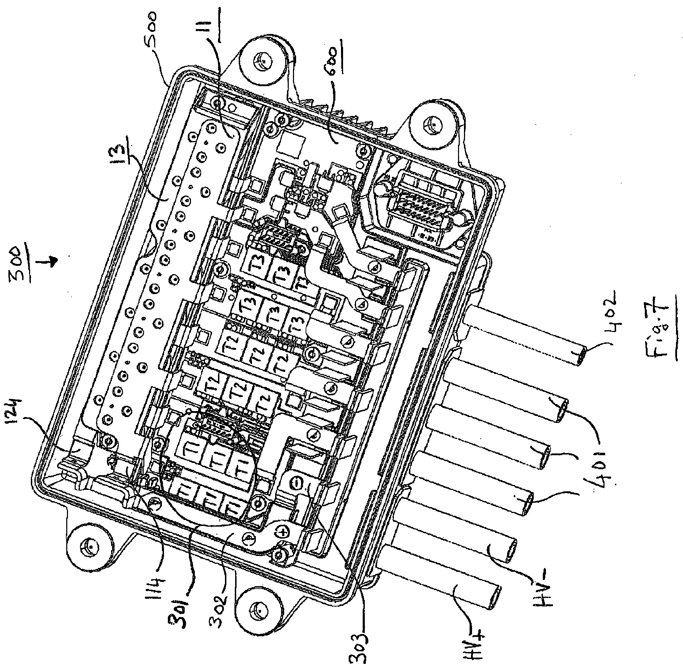

La cuve 500 permet également de recevoir la carte de circuit imprimé PCB du convertisseur électronique 300 comprenant le circuit intégré, les composants discrets, les transistors T, à savoir tel qu'illustré sur la figure 7. Dans un exemple non limitatif, els transistors T sont des MOSFET.

Ainsi, un convertisseur électronique 300 comporte :
- le dispositif d'assemblage 100 décrit précédemment ;
- la pluralité de capacités 200 adaptées pour être assemblées par le dispositif d'assemblage 100 ;
- une carte de circuit imprimé 600 formant le circuit électrique dudit convertisseur électronique 300, ladite carte de circuit imprimé comprenant la pluralité de bras 301 munis de transistors T.

Dans l'exemple non limitatif illustré le convertisseur électronique 300 comporte trois bras 301, chaque bras comprenant une série de transistors T. Ainsi, tel qu'illustré à la figure 7, le premier bras 301 comporte six transistors T1, le deuxième bras, six transistors T2, et le troisième bras six transistors T3.

Les transistors T, les composants discrets et le circuit intégré formant le convertisseur électronique sont montés sur une carte PCB 600. Cette dernière comporte également en périphérie des pistes d'alimentation 302 et 303 et des pistes de phase 401 a, 401 b, 401 c.

Chaque bras 301 est alimenté en tension positive HV+ et négative HV- au moyen de la piste d'alimentation positive 302 et de la piste d'alimentation négative 303 qui sont soudées respectivement au bras 114 du bus barre positif 11 du dispositif d'assemblage 100 et au bras 124 du bus barre négatif 12 du dispositif d'assemblage 100.

Par ailleurs, comme on peut le voir sur la figure 7, les pattes d'alimentation 110 et 120 des bus barres positif et négatif sont soudées respectivement sur les électrodes positives et négatives des différents bras de transistors T.

On notera que dans le cadre de l'application véhicule automobile, le convertisseur électronique 300 permet de filtrer le courant d'une machine électrique 400. Dans un mode de réalisation non limitatif, la machine électrique est une machine réversible telle qu'un alterno-démarreur de véhicule automobile, ladite machine ayant une puissance de l'ordre de 10kW.

Elle a pour fonctions le freinage récupératif, l'assistance au couple moteur, ou encore une fonction d'arrêt et de redémarrage automatique du moteur du véhicule automobile.

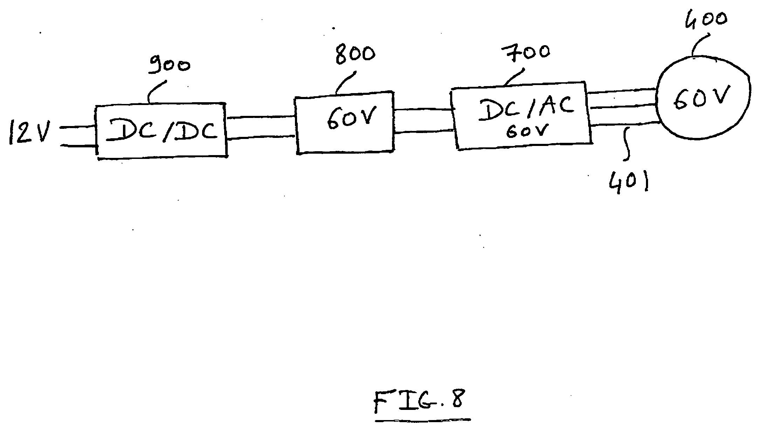

Tel qu'illustré sur le schéma électrique simplifié de la figure 8, la machine électrique 400 est une machine triphasée alimentée par une tension de 60 Volts par exemple, et connectée un onduleur 700 qui est un convertisseur DC/AC. Ce dernier est lui-même relié à une batterie 800 du véhicule qui est alimentée en 60 Volts. Enfin, un convertisseur de tension DC/DC 900 est relié à la batterie 800 du véhicule et permet de convertir la tension de 60 Volts en une tension de 12 Volts, cette dernière permettant d'alimenter le réseau du véhicule automobile.

Dans un premier mode de réalisation, le convertisseur électronique 300 est relié à la machine électrique 400. Plus particulièrement, chaque bras 301 du convertisseur électronique 300 est relié à chaque phase 401 de la machine électrique tels qu'illustrés sur la figure 7. Le convertisseur électronique est donc l'onduleur DC-AC réversible qui permet de transformer une tension triphasée en tension continue.

Dans un deuxième mode de réalisation non limitatif, le convertisseur électronique 300 est le convertisseur bidirectionnel DC/DC qui permet de transformer la tension batterie de 60 Volts en une tension réseau d'alimentation du véhicule automobile de 12 Volts.

Bien entendu, le dispositif d'assemblage n'est pas limité à l'application d'un convertisseur électronique pour véhicule automobile, mais peut être utilisé dans n'importe quel boîtier électronique qui a pour fonction de filtrer le courant et qui utilise donc des capacités de filtrage.

Par ailleurs, le dispositif d'assemblage n'est pas limité au mode de réalisation décrit précédemment. Ainsi, le dispositif d'assemblage peut être agencé de sorte à pouvoir utiliser des capacités « soldering stars » ayant trois broches négatives disposées à 120° l'une de l'autre. Il peut être également agencé de sorte à pouvoir utiliser des capacités ayant une seule broche négative.

Ainsi, la présente invention présente les avantages supplémentaires suivants :
- elle permet de réduire l'inductance du convertisseur électronique, le courant ne traversant plus la carte PCB du convertisseur ;
- elle permet de réduire le poids de la carte PCB du convertisseur car cette dernière ne supporte plus le poids des capacités ;
- elle permet de réduire la surface de la carte PCB du convertisseur car elle n'a plus besoin de contenir les pistes électriques pour faire passer le courant ;
- elle permet le positionnement de l'ensemble du dispositif d'assemblage 100 dans la cuve 500 grâce à la pièce support 13 ;
- elle permet une indexation du bus barre négatif 12 grâce à la pièce support 13;
- elle permet de réduire le coût du bus barre positif 11 car sa largeur est inférieure à celle du bus barre négatif 12 ;
- elle évite d'utiliser des pistes conductrices qui traversent la carte PCB et évite ainsi le passage du courant au travers de telles pistes cuivrées ;
- elle permet d'assurer un positionnement précis des capacités 200 dans leur logement respectif 501 grâce à la pièce d'indexation 133 de la pièce support 13. Les capacités 200 sont ainsi concentriques par rapport aux logements cylindriques 501 et ne touchent pas la cuve 500 en cours de fonctionnement. Cela évite ainsi des effets parasites CEM en cours de fonctionnement. En effet, la cuve 500 est montée en général sur la caisse

du véhicule automobile qui est à la masse du réseau 12V du véhicule. Par contre les capacités sont sur la masse HV- par laquelle des courants issus de l'alimentation en tension 60V passent.

## Revendications

1. Dispositif d'assemblage (100) de capacités (200) pour convertisseur électronique (300) comprenant une pluralité de bras (301) munis de transistors (T), ledit dispositif d'assemblage (100) comportant un bus barre de polarité positive (11) comprenant une pluralité de pattes d'alimentation (110), chaque patte d'alimentation étant adaptée pour être connectée à une électrode positive de chaque bras (301) dudit convertisseur électronique (300), et un bus barre de polarité négative (12) comprenant une pluralité de pattes d'alimentation (120), chaque patte d'alimentation étant adaptée pour être connectée à une électrode négative de chaque bras (301) dudit convertisseur électronique (300), le bus barre de polarité positive (11) et le bus barre de polarité négative (12) étant superposés l'un sur l'autre sans contact électrique, **caractérisé en ce que**
le bus barre de polarité positive (11) comprend également:
au moins un premier orifice de positionnement (111) adapté pour recevoir une broche positive (202) d'une capacité (200) et adapté pour réaliser une liaison électrique avec ladite broche positive (202) ; et
au moins un premier orifice de dégagement (112) adapté pour permettre à une broche négative (201) d'une capacité (200) de traverser ledit bus barre de polarité positive (11) sans contact électrique ;
le bus barre de polarité négative (12) comprend également:
un deuxième orifice de dégagement (122) adapté pour permettre à une broche positive (202) d'une capacité (200) de traverser ledit bus barre de polarité négative (12) sans contact électrique ;
au moins un deuxième orifice de positionnement (121) adapté pour recevoir une broche négative (201) d'une capacité (200) et adapté pour réaliser une liaison électrique avec ladite broche négative (201) ; et
**en ce que** le dispositif comporte en outre une pièce support d'isolation et d'indexation (13) disposée entre ledit bus barre de polarité positive (11) et ledit bus barre de polarité négative (12), ladite pièce support (13) comprenant :
au moins une première pièce d'indexation (130) de ladite pièce support (13) avec le bus barre de polarité négative (12) ; et
au moins un orifice de dégagement (131) adapté pour permettre à une broche négative (201) d'une capacité (200) de traverser ladite pièce de support (13) sans contact électrique.

2. Dispositif (100) selon la revendication précédente, selon lequel le bus barre de polarité positive (11) comporte une largeur (L1) inférieure à la largeur (L2) du bus barre de polarité négative (12).

3. Dispositif (100) selon la revendication précédente, selon lequel le dispositif d'assemblage (100) est adapté pour être disposé dans une cuve (500) et selon lequel la pièce support d'isolation et d'indexation (13) comporte en outre :
une deuxième pièce d'indexation (133) dudit dispositif d'assemblage (100) avec ladite cuve (500) ;
un orifice de fixation (132) dudit dispositif d'assemblage (100) dans ladite cuve (500).

4. Dispositif (100) selon la revendication précédente, selon lequel le bus barre de polarité négative (12) et la pièce support d'isolation et d'indexation (13) comportent un dégagement (125, 135) pour recevoir un écoulement d'isolant électrique dans des logements (501) de la cuve (500) de manière à solidariser les capacités (200) de ladite cuve (500).

5. Dispositif (100) selon l'une quelconque des revendications précédentes 1 à 4, selon lequel le bus barre de polarité négative (12) comporte en outre une fonction de détrompage (126) pour assurer l'installation du bus barre de polarité négative (12) sur la pièce support d'isolation et d'indexation (13).

6. Dispositif (100) selon l'une quelconque des revendications précédentes 1 à 5, selon lequel la pièce support d'isolation et d'indexation (13) est formée d'un matériau composite formé à partir de matière plastique PBT chargé en fibre de verre.

7. Convertisseur électronique (300) comprenant une pluralité de bras (301) munis de transistors (T), selon lequel le convertisseur électronique comporte :
un dispositif d'assemblage (100) selon l'une quelconque des revendications précédentes ;
une pluralité de capacités (200) adaptées pour être assemblées par le dispositif d'assemblage (100) ;
une carte de circuit imprimé (600) formant le circuit électrique dudit convertisseur électronique (300), ladite carte de circuit imprimé (600) comprenant la pluralité de bras munis de transistors.

8. Convertisseur électronique (300) selon la revendication précédente, ledit convertisseur étant un onduleur pour machine électrique (400).

9. Convertisseur électronique (300) selon la revendication précédente 7, ledit convertisseur étant un convertisseur bidirectionnel DC/DC.

## Patentansprüche

1. Vorrichtung zur Montage (100) von Kondensatoren (200) für einen elektronischen Wandler (300), umfassend eine Vielzahl von Armen (301), die mit Transistoren (T) versehen sind, wobei die Montagevorrichtung (100) eine Stromschiene mit positiver Polarität (11), umfassend eine Vielzahl von Versorgungslaschen (110), wobei jede Versorgungslasche dazu vorgesehen ist, an eine positive Elektrode jedes Arms (301) des elektronischen Wandlers (300) angeschlossen zu werden, und eine Stromschiene mit negativer Polarität (12) besitzt, umfassend eine Vielzahl von Versorgungslaschen (120), wobei jede Versorgungslasche dazu vorgesehen ist, an eine negative Elektrode jedes Arms (301) des elektronischen Wandlers (300) angeschlossen zu werden, wobei die Stromschiene mit positiver Polarität (11) und die Stromschiene mit negativer Polarität (12) ohne elektrischen Kontakt übereinander angeordnet sind, **dadurch gekennzeichnet, dass**:
- die Stromschiene mit positiver Polarität (11) auch umfasst:
- mindestens eine erste Positionierungsöffnung (111), die dazu vorgesehen ist, eine positive Klemme (202) eines Kondensators (200) aufzunehmen und eine elektrische Verbindung mit der positiven Klemme (202) herzustellen; und
- mindestens eine erste Freigabeöffnung (112), die dazu vorgesehen ist, es einer negativen Klemme (201) eines Kondensators (200) zu ermöglichen, die Stromschiene mit positiver Polarität (11) ohne elektrischen Kontakt zu durchqueren;
- die Stromschiene mit negativer Polarität (12) auch umfasst:
- eine zweite Freigabeöffnung (122), die dazu vorgesehen ist, es einer positiven Klemme (202) eines Kondensators (200) zu ermöglichen, die Stromschiene mit negativer Polarität (12) ohne elektrischen Kontakt zu durchqueren;
- mindestens eine zweite Positionierungsöffnung (121), die dazu vorgesehen ist, eine negative Klemme (201) eines Kondensators (200) aufzunehmen und eine elektrische Verbindung mit der negativen Klemme (201) herzustellen; und
dass die Vorrichtung ferner ein Stützteil zur Isolierung und Indexierung (13) umfasst, das zwischen der Stromschiene mit positiver Polarität (11) und der Stromschiene mit negativer Polarität (12) angeordnet ist, wobei das Stützteil (13) umfasst:
- mindestens ein erstes Teil (130) zur Indexierung des Stützteils (13) mit der Stromschiene mit negativer Polarität (12); und
- mindestens eine Freigabeöffnung (131), die dazu vorgesehen ist, es einer negativen Klemme (201) eines Kondensators (200) zu ermöglichen, das Stützteil (13) ohne elektrischen Kontakt zu durchqueren.

2. Vorrichtung (100) nach dem vorhergehenden Anspruch, bei der die Stromschiene mit positiver Polarität (11) eine kleinere Breite (L1) als die Breite (L2) der Stromschiene mit negativer Polarität (12) umfasst.

3. Vorrichtung (100) nach dem vorhergehenden Anspruch, bei der die Montagevorrichtung (100) dazu vorgesehen ist, in einer Wanne (500) angeordnet zu werden, und bei der das Stützteil zur Isolierung und Indexierung (13) ferner umfasst:
- ein zweites Teil (133) zur Indexierung der Montagevorrichtung (100) mit der Wanne (500);
- eine Öffnung zur Befestigung (132) der Montagevorrichtung (100) in der Wanne (500).

4. Vorrichtung (100) nach dem vorhergehenden Anspruch, bei der die Stromschiene mit negativer Polarität (12) und das Stützteil zur Isolierung und Indexierung (13) eine Ausnehmung (125, 135) umfassen, um einen Strom eines elektrischen Isoliermittels in Lagerungen (501) der Wanne (500) aufzunehmen, um die Kondensatoren (200) der Wanne (500) zu verbinden.

5. Vorrichtung (100) nach einem der vorhergehenden Ansprüche 1 bis 4, bei der die Stromschiene mit negativer Polarität (12) ferner eine Unverwechselbarkeitsfunktion (126) umfasst, um die Installation der Stromschiene mit negativer Polarität (12) auf dem Stützteil zur Isolierung und Indexierung (13) zu gewährleisten.

6. Vorrichtung (100) nach einem der vorhergehenden Ansprüche 1 bis 5, bei der das Stützteil zur Isolierung und Indexierung (13) aus einem Verbundmaterial besteht, das aus mit Glasfasern verstärktem Kunststoff PBT gebildet ist.

7. Elektronischer Wandler (300), umfassend eine Vielzahl von Armen (301), die mit Transistoren (T) versehen sind, wobei der elektronische Wandler umfasst:
- eine Montagevorrichtung (100) nach einem der vorhergehenden Ansprüche;
- eine Vielzahl von Kondensatoren (200), die dazu vorgesehen sind, durch die Montagevorrichtung (100) zusammengebaut zu werden;
- eine Leiterplatine (600), die die elektrische Schaltung des elektronischen Wandlers (300) bildet, wobei die Leiterplatine (600) eine Vielzahl von mit Transistoren versehenen Armen umfasst.

8. Elektronischer Wandler (300) nach dem vorhergehenden Anspruch, wobei der Wandler ein Wechselrichter für eine elektrische Maschine (400) ist.

9. Elektronischer Wandler (300) nach dem vorhergehenden Anspruch 7, wobei der Wandler ein bidirektionaler DC/DC-Wandler ist.

## Claims

1. Device for assembling (100) capacitors (200) for an electronic converter (300) comprising a plurality of arms (301) provided with transistors (T), said assembly device (100) comprising a busbar of positive polarity (11) comprising a plurality of power supply taps (110), each power supply tap being adapted to be connected to a positive electrode of each arm (301) of said electronic converter (300), and a busbar of negative polarity (12) comprising a plurality of power supply taps (120), each power supply tap being adapted to be connected to a negative electrode of each arm (301) of said electronic converter (300), the busbar of positive polarity (11) and the busbar of negative polarity (12) being superposed one on top of the other without electrical contact, **characterized in that** the busbar of positive polarity (11) also comprises:
at least one first positioning orifice (111) adapted to receive a positive pin (202) of a capacitor (200) and adapted to produce an electrical link with said positive pin (202); and
at least one first clearance orifice (112) adapted to allow a negative pin (201) of a capacitor (200) to pass through said busbar of positive polarity (11) without electrical contact;
the busbar of negative polarity (12) also comprises:
a second clearance orifice (122) adapted to allow a positive pin (202) of a capacitor (200) to pass through said busbar of negative polarity (12) without electrical contact;
at least one second positioning orifice (121) adapted to receive a negative pin (201) of a capacitor (200) and adapted to produce an electrical link with said negative pin (201); and
**in that** the device further comprises an insulating and indexing support piece (13) arranged between said busbar of positive polarity (11) and said busbar of negative polarity (12), said support piece (13) comprising:
at least one first indexing piece (130) for indexing said support piece (13) with the busbar of negative polarity (12); and
at least one clearance orifice (131) adapted to allow a negative pin (201) of a capacitor (200) to pass through said support piece (13) without electrical contact.

2. Device (100) according to the preceding claim, according to which the busbar of positive polarity (11) has a width (L1) less than the width (L2) of the busbar of negative polarity (12).

3. Device (100) according to the preceding claim, according to which the assembly device (100) is adapted to be arranged in a tank (500) and according to which the insulating and indexing support piece (13) further comprises:
a second indexing piece (133) for indexing said assembly device (100) with said tank (500);
a fixing orifice (132) for fixing said assembly device (100) in said tank (500).

4. Device (100) according to the preceding claim, according to which the busbar of negative polarity (12) and the insulating and indexing support piece (13) comprise a clearance (125, 135) for receiving a flow of electrical insulator in housings (501) of the tank (500) so as to secure the capacitors (200) of said tank (500).

5. Device (100) according to any one of the preceding Claims 1 to 4, according to which the busbar of negative polarity (12) further comprises a polarizing function (126) for ensuring the installation of the busbar of negative polarity (12) on the insulating and indexing support piece (13).

6. Device (100) according to any one of the preceding Claims 1 to 5, according to which the insulating and indexing support piece (13) is formed from a composite material formed from glass fibre-filled plastic material PBT.

7. Electronic converter (300) comprising a plurality of arms (301) provided with transistors (T), according to which the electronic converter comprises:
an assembly device (100) according to any one of the preceding claims;
a plurality of capacitors (200) adapted to be assembled by the assembly device (100);
a printed circuit board (600) forming the electrical circuit of said electronic converter (300), said printed circuit board (600) comprising the plurality of arms provided with transistors.

8. Electronic converter (300) according to the preceding claim, said converter being an inverter for an electrical machine (400).

9. Electronic converter (300) according to the preceding Claim 7, said converter being a DC/DC two-way converter.
